# EUROPEAN PATENT SPECIFICATION

(11) **EP 3 817 041 B1**
(45) Date of publication and mention of the grant of the patent: **16.08.2023**
(21) Application number: 19825844.4
(22) Date of filing: 26.06.2019
(51) Int. Cl.: H01L 23/12, H01L 23/36, H05K 1/02

(54) **ELECTRONIC ELEMENT MOUNTING SUBSTRATE, ELECTRONIC DEVICE, AND ELECTRONIC MODULE**
MONTAGESUBSTRAT FÜR ELEKTRONISCHES ELEMENT, ELEKTRONISCHE VORRICHTUNG UND ELEKTRONISCHES MODUL
SUBSTRAT DE MONTAGE D'ÉLÉMENT ÉLECTRONIQUE, DISPOSITIF ÉLECTRONIQUE ET MODULE ÉLECTRONIQUE

(30) Priority: 26.06.2018 JP 2018120970
(43) Date of publication of application: 05.05.2021
(73) Proprietor: Kyocera Corporation, Kyoto-shi, Kyoto 612-8501 (JP)
(72) Inventor: KITAZUMI, Noboru, Kyoto-shi, Kyoto 612-8501 (JP); MORIYAMA, Yousuke, Kyoto-shi, Kyoto 612-8501 (JP)
(74) Representative: Viering, Jentschura & Partner mbB Patent- und Rechtsanwälte
(86) International application number: PCT/JP2019/025369
(87) International publication number: WO 2020/004459

(56) References cited:
- JP-A- 2007 073 654
- JP-A- 2009 043 851
- JP-A- 2011 159 662
- JP-A- 2012 028 520
- JP-A- 2012 164 956

## Description

### Technical Field

The present invention relates to an electronic element mounting substrate, an electronic device, and an electronic module.

### Background Art

In the related art, an electronic element mounting substrate includes: an insulating substrate including a first principal face, a second principal face, and side faces; and an electronic element mounting portion and a wiring layer located on the first principal face of the insulating substrate. In the electronic element mounting substrate, an electronic element is mounted on the electronic element mounting portion. After that, the electronic element mounting substrate is installed in an electronic element housing package, thereby constituting an electronic device (refer to Japanese Unexamined Patent Publication JP-A 2013-175508).

JP 2007 073654 A discloses a carbon layer having a heat conductivity being formed in an inner layer or surface layer of an insulating member in a laminated manner, and heat radiation members having a heat conductivity being formed to come into contact with the carbon layer and extend from the contact portion to a surface (board surface) of the insulating member. Thus, heat generating from the electronic parts is conducted to the carbon layer and is spread in the carbon layer. Thereafter, heat spread in the carbon layer is conducted (radiated) to the board surface via the heat radiation members, and further, is conducted to an external case connected to the heat radiation members.

JP 2009 043851 A discloses a semiconductor element that is mounted on one element mounting surface, and a base plate with the other attaching surface thermally coupled and arranged to a heatsink that is formed by a metallic material layer. A plurality of graphite sheets more excellent in thermal conductivity efficiency than the metallic material layer are arranged between the element mounting surface and the attaching surface so that the surface direction more excellent in thermal conductivity than the surface-perpendicular direction of the metallic material layer intersects with the element mounting surface.

JP 2012 028520 A discloses a semiconductor element and a heat absorption section being mounted on one surface of an electrode section. A graphite heat diffusion plate is used as the electrode section. In the graphite heat diffusion plate, each of one direction parallel to the one surface of the electrode section and a thickness direction from the semiconductor element toward a first cooler is a high heat conductivity direction in which heat conductivity is higher at the one direction and the thickness direction than a direction different from the one direction and the thickness direction. The heat absorption section is disposed on an extension line of the one direction from a disposed place of the semiconductor element on the one surface of the electrode section. With this configuration, a transitional heat generated at the semiconductor element is conducted from the semiconductor element to the graphite heat diffusion plate and also conducted to the heat absorption section along the one direction that is a high heat conductivity direction.

JP 2011 159662 A discloses a semiconductor device including a semiconductor element, a junction, and a heat sink laminated in order. A direction in which the semiconductor element and the heat sink are laminated is assumed as a thickness direction, and a direction along a plane perpendicular to the thickness direction is assumed as a plane direction. The heat sink includes: a first embedded portion formed in a central region corresponding to a laminate range of the semiconductor element, the heat sink having a thermal conductivity in the thickness direction higher than the thermal conductivity in the plane direction and the thermal conductivity of a base material of the heat sink; and a second embedded portion formed in a peripheral region, the second embedded portion having a linear expansion coefficient in the plane direction smaller than the linear expansion coefficient in the plane direction of the first embedded portion and the linear expansion coefficient of the base material of the heat sink and having a rigidity in the plane direction higher than the rigidity in the plane direction of the first embedded portion and the rigidity of the base material of the heat sink.

JP 2012 164956 A discloses a substrate including a through electrode and a plurality of columnar heat sinks, with one surface containing a recess which is to be an electronic component arrangement region. The through electrode penetrates the substrate along a thickness direction, with an end being exposed from the inner surface of the recess. The columnar heat sinks are provided along the thickness direction of the substrate, being arranged with a short interval to surround the recess, with respective one ends connected in common to a heat radiation layer stuck to the other surface of the substrate. An electronic component is arranged inside the recess of the substrate, and an electrode provided on one surface is connected to one end of the through electrode.

### Summary of Invention

### Solution to Problem

An electronic element mounting substrate according to the present disclosure includes: a first substrate including a first principal face and a second principal face located opposite to the first principal face; a second substrate located inside the first substrate in a plan view of the electronic element mounting substrate, , the second substrate including a third principal face located on a first principal face side in a thickness direction of the second substrate and a fourth principal face located opposite to the third principal face, the second substrate being made of a carbon material; and a plurality of via conductors that are, in the plan view of the electronic element mounting substrate, arranged in the first substrate with the second substrate in between, in the plan view of the electronic element mounting substrate, heat conduction of the second substrate being greater in a direction perpendicular to a direction in which the plurality of via conductors are arranged with the second substrate in between than in the direction in which the plurality of via conductors are arranged with the second substrate in between.

An electronic device according to the disclosure includes: the electronic element mounting substrate mentioned above; an electronic element mounted on a mounting portion of the electronic element mounting substrate; and a wiring substrate or electronic element housing package installed with the electronic element mounting substrate.

An electronic module according to the disclosure includes: the electronic device mentioned above; and a module substrate to which the electronic device is connected.

### Brief Description of Drawings

FIG. 1(a) is a top view showing an electronic element mounting substrate according to a first embodiment, and FIG. 1(b) is a bottom view of the substrate shown in FIG. 1(a);
FIG. 2 is an exploded perspective view showing a first substrate and a second substrate of the electronic element mounting substrate shown in FIG. 1 in a disassembled state;
FIG. 3 is a vertical sectional view of the electronic element mounting substrate taken along the line A-A shown in FIG. 1(a);
FIG. 4(a) is a top view showing the electronic element mounting substrate shown in FIG. 1(a) on which an electronic device is mounted, and FIG. 4(b) is a vertical sectional view of the substrate taken along the line A-A shown in FIG. 4(a);
FIG. 5(a) is a top view showing an electronic element mounting substrate according to a second embodiment, and FIG. 5(b) is a bottom view of the substrate shown in FIG. 5(a);
FIG. 6 is an exploded perspective view showing a first substrate and a second substrate of the electronic element mounting substrate shown in FIG. 4 in a disassembled state;
FIG. 7(a) is a vertical sectional view of the electronic element mounting substrate taken along the line A-A shown in FIG. 5(a), and FIG. 7(b) is a vertical sectional view of the electronic element mounting substrate taken along the line B-B shown in FIG. 5(a);
FIG. 8(a) is a top view showing the electronic element mounting substrate shown in FIG. 5(a) on which an electronic element is mounted, and FIG. 8(b) is a vertical sectional view of the substrate taken along the line A-A shown in FIG. 8(a);
FIG. 9(a) is a top view showing an electronic element mounting substrate according to a third embodiment, and FIG. 9(b) is a bottom view of the substrate shown in FIG. 9(a);
FIG. 10 is an exploded perspective view showing a first substrate and a second substrate of the electronic element mounting substrate shown in FIG. 9 in a disassembled state;
FIG. 11(a) is a vertical sectional view of the electronic element mounting substrate taken along the line A-A shown in FIG. 9(a), and FIG. 11(b) is a vertical sectional view of the electronic element mounting substrate taken along the line B-B shown in FIG. 9(a);
FIG. 12(a) is a top view showing the electronic element mounting substrate shown in FIG. 9(a) on which an electronic element is mounted, and FIG. 12(b) is a vertical sectional view of the substrate taken along the line A-A shown in FIG. 12(a);
FIGS. 13(a) and 13(b) are each a top view of another example of the electronic element mounting substrate shown in FIG. 9(a) on which an electronic element is mounted;
FIG. 14(a) is a top view showing an electronic element mounting substrate according to a fourth embodiment, and FIG. 14(b) is a bottom view of the substrate shown in FIG. 14(a);
FIG. 15 is an exploded perspective view showing a first substrate, a third substrate, a fourth substrate, and a second substrate of the electronic element mounting substrate shown in FIG. 14 in a disassembled state;
FIG. 16(a) is a vertical sectional view of the electronic element mounting substrate taken along the line A-A shown in FIG. 14(a), and FIG. 16(b) is a vertical sectional view of the electronic element mounting substrate taken along the line B-B shown in FIG. 14(a);
FIG. 17(a) is a top view showing another example of the electronic element mounting substrate according to the fourth embodiment, and FIG. 17(b) is a bottom view of the substrate shown in FIG. 17(a);
FIG. 18 is an exploded perspective view showing a first substrate, a third substrate, a fourth substrate, and a second substrate of the electronic element mounting substrate shown in FIG. 17 in a disassembled state;
FIG. 19(a) is a vertical sectional view of the electronic element mounting substrate taken along the line A-A shown in FIG. 17(a), and FIG. 19(b) is a vertical sectional view of the electronic element mounting substrate taken along the line B-B shown in FIG. 17(a);
FIG. 20(a) is a top view showing still another example of the electronic element mounting substrate according to the fourth embodiment, and FIG. 20(b) is a bottom view of the substrate shown in FIG. 20(a); and
FIG. 21(a) is a vertical sectional view of the electronic element mounting substrate taken along the line A-A shown in FIG. 20(a), and FIG. 21(b) is a vertical sectional view of the electronic element mounting substrate taken along the line B-B shown in FIG. 20(a).

### Description of Embodiments

Several exemplary embodiments of the disclosure will now be described with reference to the accompanying drawings.

### (First Embodiment)

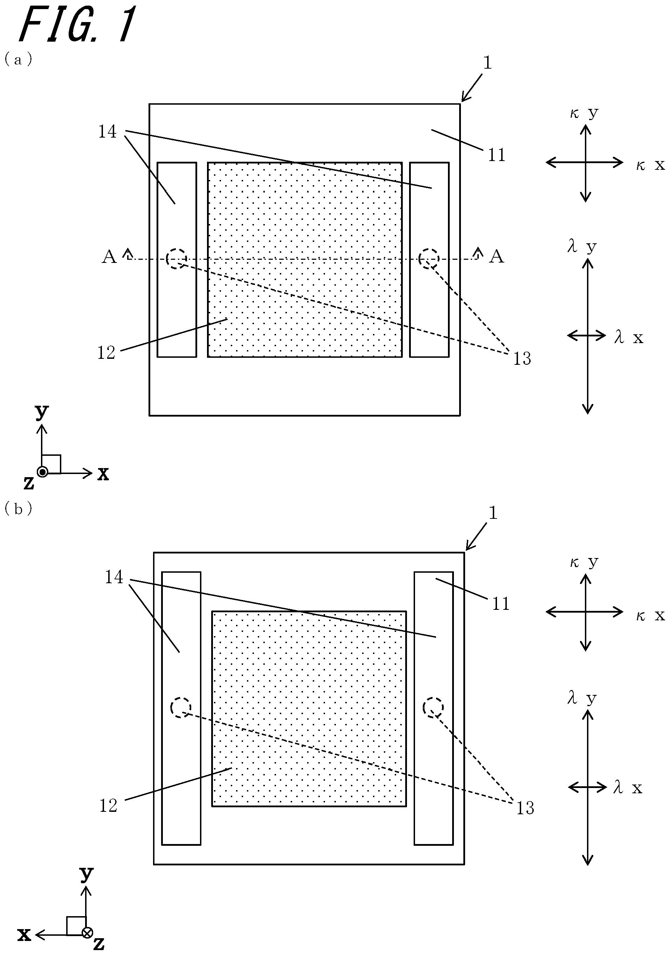

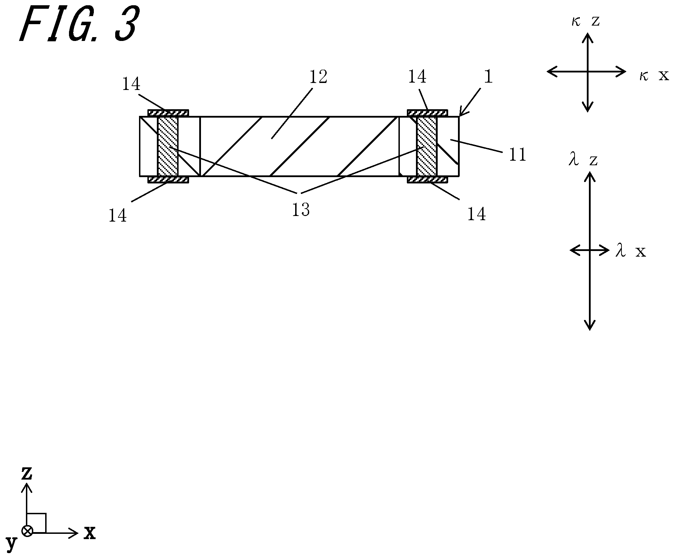

As illustrated in FIGS. 1 to 4, an electronic element mounting substrate 1 for an electronic element to be mounted according to a first embodiment of the disclosure includes a first substrate 11 and a second substrate 12. For example, an electronic device includes the electronic element mounting substrate 1, an electronic element 2 mounted on a mounting portion of the electronic element mounting substrate 1, and a wiring substrate installed with the electronic element mounting substrate 1. For example, the electronic device is connected via a joining material to a connection pad disposed on a module substrate constituting an electronic module.

The electronic element mounting substrate 1 according to this embodiment includes: the first substrate 11 including a first principal face and a second principal face located opposite to the first principal face; the second substrate 12 located inside the first substrate 11 in a plan view, the second substrate 12 including a third principal face located on the first principal face side in a thickness direction of the second substrate 12 and a fourth principal face located opposite to the third principal face, the second substrate being made of a carbon material; and a plurality of via conductors 13 that are, in the plan view, arranged in the first substrate 11 with the second substrate 12 in between. In the plan view, heat conduction of the second substrate 12 is greater in a direction perpendicular to a direction in which the plurality of via conductors 13 are arranged with the second substrate 12 in between (y direction as viewed in FIGS. 1 to 4) than in the direction in which the via conductors 13 are arranged with the second substrate 12 in between (x direction as viewed in FIGS. 1 to 4). Conductor layers 14 disposed on the first principal face and the second principal face, respectively, of the first substrate 11. Each conductor layer 14 is connected to corresponding one of the ends of the via conductor 13. In FIGS. 1 to 4, the electronic element 2 is shown as mounted on an xy plane in an imaginary xyz space. In FIGS. 1 to 4, an upward direction conforms to a positive direction along an imaginary z axis. In the following description, the terms "upper" and "lower" are used as a matter of convenience and are not intended to be limiting of the oriented positions of the electronic element mounting substrate 1, etc. in a vertical direction in terms of actual usage.

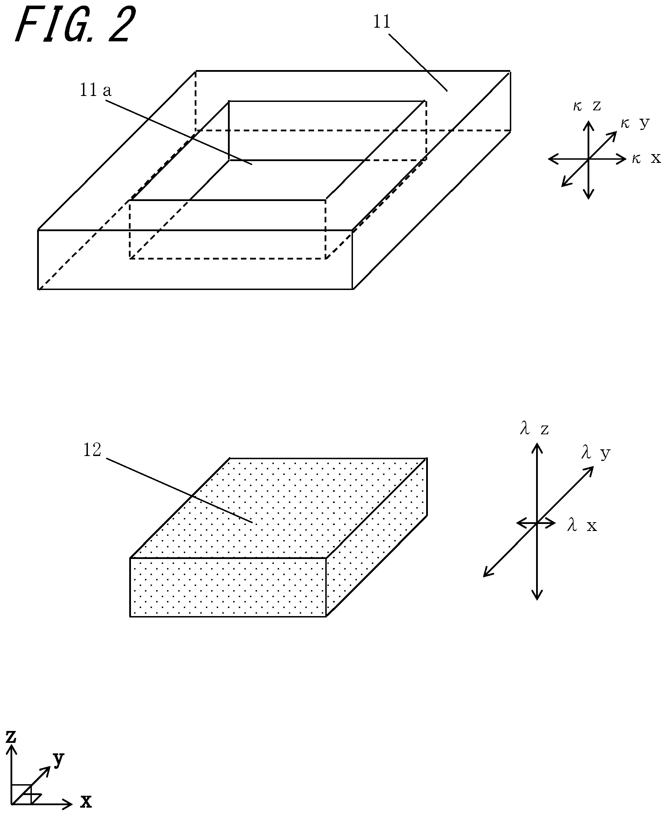

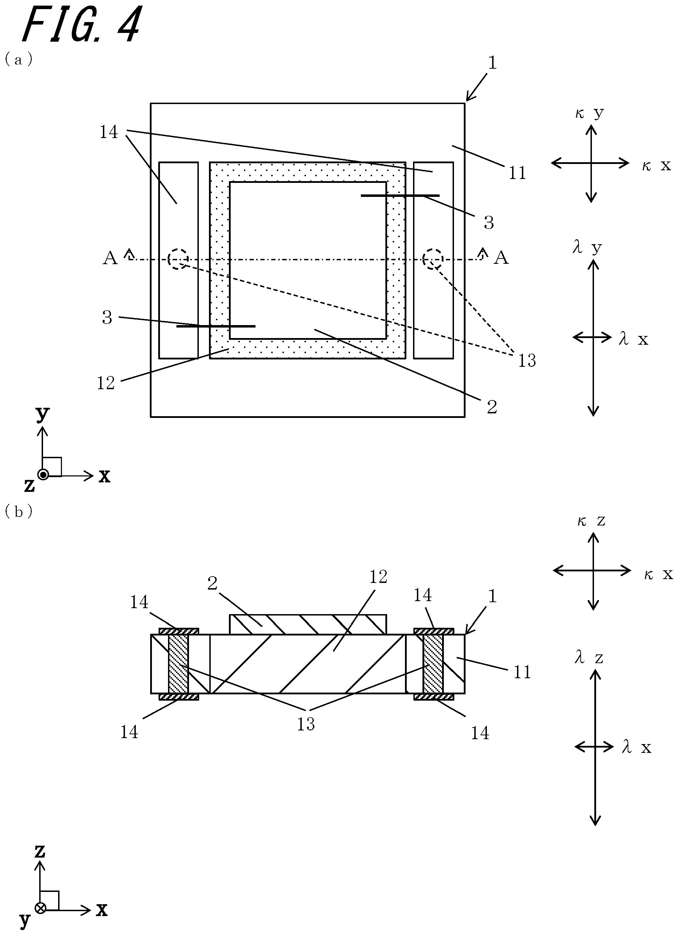

In FIG. 2, in the illustrated first substrate 11, the outer surface of the first substrate 11 and the inner surface of a through hole 11a, which become invisible as viewed in perspective, are indicated by dotted lines. In FIGS. 1, 2, and 4(a), the illustrated second substrate 12 is indicated by a dot-shaded area. In FIGS. 1 and 4(a), in the plan view, a part of overlap of the periphery of the via conductor 13 and the conductor layer 14 is indicated by dotted lines.

The first substrate 11 has the first principal face (upper surface as viewed in FIGS. 1 to 4) and the second principal face (lower surface as viewed in FIGS. 1 to 4). The first principal face and the second principal face are located opposite to each other. The first substrate 11, including a single insulating layer or a plurality of insulating layers, is shaped in a quadrangular plate having two pairs of opposite sides (four sides in total) positioned in relation to each of the first principal face and the second principal face in the plan view. The first substrate 11 serves as a support for supporting the electronic element 2 and the second substrate 12.

For example, the first substrate 11 may be made of ceramics such as an aluminum oxide sintered body (alumina ceramic), an aluminum nitride sintered body, a mullite sintered body, and a glass ceramics sintered body. For example, in the case where an aluminum nitride sintered body is used for the first substrate 11, a way to produce the first substrate 11 including a single insulating layer or a plurality of insulating layers is as follows. A slurry is prepared first by admixing suitable organic binder, solvent, etc. in raw material powder such as aluminum nitride (AlN), erbium oxide (Er₂O₃), yttrium oxide (Y₂O₃), etc. The resulting slurry is shaped into a sheet by using heretofore known means such as a doctor blade method or a calender roll method, thereby forming a ceramic green sheet. On an as needed basis, a plurality of ceramic green sheets are stacked into a laminate. The ceramic green sheet or the laminate is fired at a high temperature (about 1800°C).

The second substrate 12 includes the third principal face (upper surface as viewed in FIGS. 1 to 4) located on the first principal face side of the first substrate 11, and the fourth principal face (lower surface as viewed in FIGS. 1 to 4). The third principal face and the fourth principal face are located opposite to each other. As illustrated in FIGS. 1 to 4, the second substrate 12 is located inside the first substrate 11. The second substrate 12 includes, at the third principal face, a mounting portion for mounting the electronic element 2. That is, the second substrate 12 serves as a support for supporting the electronic element 2.

For example, the second substrate 12 is made of a carbon material in the form of a graphene laminate structure containing six-membered rings joined together by covalent bonds, in which lamination planes are bound together by van der Waals' forces.

The via conductor 13 is set along the thickness direction of the first substrate 11. That is, as illustrated in FIGS. 1 to 4, the via conductor 13 is provided so as to pass through between the first principal face and the second principal face of the first substrate 11. The conductor layers 14 are disposed on the first principal face and the second principal face, respectively, of the first substrate 11, each conductor layer 14 being connected to corresponding one of the ends of the via conductor 13.

Moreover, in the plan view, the plurality of via conductors 13 are arranged in the first substrate 11 with the second substrate 12 in between. As illustrated in FIGS. 1 to 4, the direction in which the via conductors 13 are arranged with the second substrate 12 in between conforms to the x direction.

For example, the via conductor 13 and the conductor layer 14 serve to electrically connect the electronic element 2 and a wiring conductor of a wiring substrate. Moreover, the conductor layer 14 is used as a connection portion for a connecting member 3 such as a bonding wire, as well as a connection portion for connection with the wiring conductor of the wiring substrate. The via conductor 13 and the conductor layer 14 generate heat upon application of electric current for actuation of the electronic element 2.

The via conductor 13 and the conductor layer 14 are a metal powder metallization layer which contains tungsten (w), molybdenum (Mo), manganese (Mn), silver (Ag), or copper (Cu), for example, as a main component. For example, in the case where the first substrate 11 is made of an aluminum nitride sintered body, the via conductor 13 and the conductor layer 14 are each obtained by applying a metallization paste, which is prepared by admixing suitable organic binder, solvent, etc. in high-melting-point metal powder such as W, Mo, or Mn, in a predetermined pattern to the ceramic green sheet for the first substrate 11 by printing using a screen printing method, and thereafter firing the paste together with the ceramic green sheet for the first substrate 11. For example, the via conductor 13 is obtained by forming a through hole for receiving a through conductor in the ceramic green sheet for the first substrate 11 by hole-boring operation, e.g. punching using a punching die or a punch, or lasering, then applying the metallization paste for forming the via conductor 13 so as to fill the above-described through hole by printing using printing means, e.g. the screen printing method, and thereafter firing the paste together with the ceramic green sheet for the first substrate 11. For example, the conductor layer 14 is obtained by applying the metallization paste for forming the conductor layer 14 to a predetermined area on the surface of the ceramic green sheet for the first substrate 11 by printing using the above-described printing means, and thereafter firing the paste together with the ceramic green sheet for the first substrate 11. The metallization paste is prepared by kneading the above-described metal powder with suitable solvent and binder while adjusting the viscosity of the mixture to an adequate level. In the interest of strengthening of bonding with the first substrate 11, the metallization paste may contain glass powder and ceramic powder.

A metallic plating layer is deposited on a surface of the conductor layer 14 exposed on the first substrate 11 by electroplating or electroless plating. The metallic plating layer is made of metal which is highly resistant to corrosion and affords high connectability to the connecting member, e.g. nickel, copper, gold, or silver. For example, the exposed surface is deposited successively with a nickel plating layer measuring about 0.5 to 5 um in thickness and a gold plating layer measuring about 0.1 to 3 um in thickness. The metallic plating layer can retard corrosion of the conductor layer 14 effectively, and also can strengthen the connection between the conductor layer 14 and the connecting member 3 such as a bonding wire, as well as the connection between the conductor layer 14 and a connection pad formed for connection purposes on a module substrate.

Moreover, the metallic plating layer is not limited to the nickel plating layer/gold plating layer structure. For example, the use of a metallic plating layer of nickel plating layer/palladium plating layer/gold plating layer structure is entirely satisfactory.

An aluminum nitride sintered body which excels in thermal conductivity is preferably used for the first substrate 1. The joining together of the first substrate 11 and the second substrate 12 is accomplished by bonding the outer surface of the second substrate 12 to the inner surface of the through hole 11a of the first substrate 11 via a joining material made of an active brazing filler metal, e.g. a Ti-Cu-Ag alloy or a Ti-Sn-Ag-Cu alloy. The joining material, which is about 10 um thick, is interposed between the first substrate 11 and the second substrate 12.

The first substrate 11 is quadrangular in plan configuration. In the plan view, the first substrate 11 is provided with the quadrangular through hole 11a formed so as to pass through between the first principal face and the second principal face thereof. The first substrate 11 may be shaped in a frame. The second substrate 12 is quadrangular in plan configuration. The periphery of the second substrate 12 is bonded to the inner surface of the through hole 11a of the first substrate 11, thereby constituting a quadrangular composite substrate. As used herein the term "quadrangular configuration" means the shape of a quadrilateral such as a square and a rectangle. As illustrated in FIGS. 1 to 4, the first substrate 11 and the second substrate 12 are each square in plan configuration. Thus, the composite substrate having a square form is formed.

For example, a thickness T1 of the first substrate 11 is about 100 um to 2000 um, and a thickness T2 of the second substrate 12 is about 100 um to 2000 um. That is, the thickness T1 of the first substrate 11 and the thickness T2 of the second substrate 12 are substantially equal (0.9T1 ≤ T2 ≤ 1.1T1).

As illustrated in FIG. 2, in a planar direction of the first substrate 11, a thermal conductivity κ of the first substrate 11 in the x direction and a thermal conductivity κ thereof in the y direction are substantially uniform. Moreover, in a thickness direction of the first substrate 11, a thermal conductivity κ of the first substrate 11 in the z direction is approximately equal to the thermal conductivity κ in the planar direction, i.e. the x direction and the y direction (κx ≈ κy ≈ κz). For example, in the case where an aluminum nitride sintered body is used for the first substrate 11, the first substrate 11 is constructed of a substrate having a thermal conductivity κ of about 100 to 200 W/m·κ.

On the other hand, in the planar direction of the second substrate 12, a thermal conductivity λ of the second substrate 12 in the x direction and a thermal conductivity λ thereof in the y direction differ in level from each other. That is, in the second substrate 12, the thermal conductivity λ in the y direction corresponding to the planar direction and the thermal conductivity λ in the z direction corresponding to the thickness direction are approximately equal to each other, but the thermal conductivity λ in the x direction corresponding to the planar direction is different from them. The relationship among the thermal conductivities λ of the second substrate 12 in different directions shown in FIG. 2, namely the relationship among λx, λy, and λz is expressed as: "thermal conductivity λy ≈thermal conductivity λz >> thermal conductivity λx". For example, the thermal conductivity λy and the thermal conductivity λz of the second substrate 12 are each about 1000 W/m·K, whereas the thermal conductivity λx of the second substrate 12 is about 4 W/m-K. In some drawings for this embodiment, as well as in some drawings for embodiments that will hereinafter be described, one of the thermal conductivities κx, κy, κz, λx, λy, and λz may be omitted for the sake of convenience.

The electronic device can be produced by mounting the electronic element 2 on the mounting portion of the second substrate 12 of the electronic element mounting substrate 1. As illustrated in FIG. 4, the electronic element 2 is located on the mounting portion of the second substrate 12 so as to lie between the via conductors 13. It is also satisfactory to produce the electronic device by installing the electronic element mounting substrate 1 on which the electronic element 2 is mounted in a wiring substrate or electronic element housing package. Examples of the electronic element 2 mounted on the electronic element mounting substrate 1 include light-emitting elements such as LD (Laser Diode) and LED (Light Emitting Diode) and light-receiving elements such as PD (Photo Diode). For example, the electronic element 2 is fixedly disposed on the mounting portion of the second substrate 12 via a joining material such as a Au-Sn material. After that, an electrode of the electronic element 2 is electrically connected to the conductor layer 14 via the connecting member 3 such as a bonding wire. Thus, the electronic element 2 is mounted on the electronic element mounting substrate 1. If using a wiring substrate or electronic element housing package which is installed with the electronic element mounting substrate 1, the wiring substrate or electronic element housing package may be, like the first substrate 11, constructed of an insulating base body made of ceramics or the like and includes a wiring conductor on a surface thereof. Moreover, if using a wiring substrate or electronic element housing package which is installed with the electronic element mounting substrate 1, the conductor layer 14 of the electronic element mounting substrate 1 is electrically connected to the wiring conductor of the wiring substrate or electronic element housing package.

The electronic element mounting substrate 1 according to this embodiment includes: the first substrate 11 including the first principal face and the second principal face located opposite to the first principal face; the second substrate 12 located inside the first substrate 11 in the plan view the second substrate 12 including the third principal face located on the first principal face side in the thickness direction and the fourth principal face located opposite to the third principal face, the second substrate 12 being made of a carbon material; and the plurality of via conductors 13 that are, in the plan view, arranged in the first substrate 11 with the second substrate 12 in between, wherein, in the plan view, heat conduction of the second substrate 12 is greater in a direction perpendicular to the direction in which the plurality of via conductors 13 are arranged with the second substrate 12 in between than in the direction in which the via conductors 13 are arranged with the second substrate 12 in between. In this construction, for example, if the via conductor 13 generates heat during operation of the electronic device, in the entire thickness of the via conductor 13 (z direction), the heat transmitted to the second substrate 12 from the via conductor 13 is transmitted from the outer edge area of the second substrate 12 in the direction perpendicular to the direction in which the plurality of via conductors 13 are arranged with the second substrate 12 in between along the outer edge of the first substrate 11. This makes it possible to reduce transmission of heat from the via conductor 13 to the electronic element 2, to achieve good dissipation of heat from the via conductor 13, and to reduce a decrease in the output of the electronic element 2.

Moreover, in the case where a light-emitting element is used as the electronic element 2, the electronic element mounting substrate is capable of reducing a decrease in the output of the light-emitting element, ensuring satisfactory light emission from the light-emitting element.

Moreover, heat from the electronic element 2 is transmitted both in a direction of the second substrate 12 which is perpendicular to the direction in which the plurality of via conductors 13 are arranged with the second substrate 12 in between and in the thickness direction of the second substrate 12. This permits good dissipation of the heat from the electronic element 2 and thus can reduce a decrease in the output of the electronic element 2.

The electronic device according to this embodiment includes the element mounting substrate 1 mentioned above and the electronic element 2 mounted on the mounting portion of the electronic element mounting substrate 1. Thus constructed, the electronic device can remain reliable for long periods.

The electronic device according to this embodiment is connected, at the conductor layer of the electronic element mounting substrate 1, to the connection pad of the module substrate via a joining material such as solder, thereby constituting the electronic module. Thus, the electronic element 2 and the connection pad of the module substrate are electrically connected to each other.

Moreover, in the case where the electronic device includes a wiring substrate or electronic element housing package installed with the electronic element mounting substrate 1, the electronic device is connected, at the wiring conductor of the wiring substrate or electronic element housing package, to the connection pad of the module substrate via a joining material such as solder, thereby constituting the electronic module. Thus, the electronic element 2 and the connection pad of the module substrate are electrically connected to each other.

The electronic module according to this embodiment includes the electronic device mentioned above and the module substrate to which the electronic device is connected. Thus constructed, the electronic module can remain reliable for long periods.

Moreover, in a vertical sectional view in the direction in which the plurality of via conductors 13 are arranged with the second substrate 12 in between in the plan view (x direction as viewed in FIG. 1), preferably, heat conduction of the second substrate 12 is greater in the thickness direction than in a direction perpendicular to the thickness direction (λz >> λx). In this case, the heat transmitted to the second substrate 12 from the via conductor 13 is less likely to remain in the interior of the second substrate 12, and thus, in the entire thickness of the via conductor 13 (z direction), the heat is transmitted from the outer edge area of the second substrate 12 in a direction perpendicular to the direction in which the plurality of via conductors 13 are arranged with the second substrate 12 in between along the outer edge of the first substrate 11. This makes it possible to reduce transmission of heat from the via conductor 13 to the electronic element 2, to achieve good dissipation of heat from the via conductor 13, and to reduce a decrease in the output of the electronic element 2.

While the via conductor 13 disposed within the first substrate 11 and the conductor layer 14 disposed on each of the first principal face and the second principal face of the first substrate 11 are, as exemplified, formed by using co-firing, the via conductor 13 and the conductor layer 14 may be formed by using heretofore known thin-film method and plating. Moreover, for example, heretofore known post-firing may be adopted for the formation of the conductor layer 14 disposed on the first principal face or the second principal face of the first substrate 11.

In the case where the via conductor 13 and the conductor layer 14 are formed by using the thin-film method and plating, after the first substrate 11 and the second substrate 12 are bonded to each other via a joining material into a composite substrate, the first substrate 11 is provided with the via conductor 13 and the conductor layer 14. This permits satisfactory formation of the electronic element mounting substrate 1.

### (Second Embodiment)

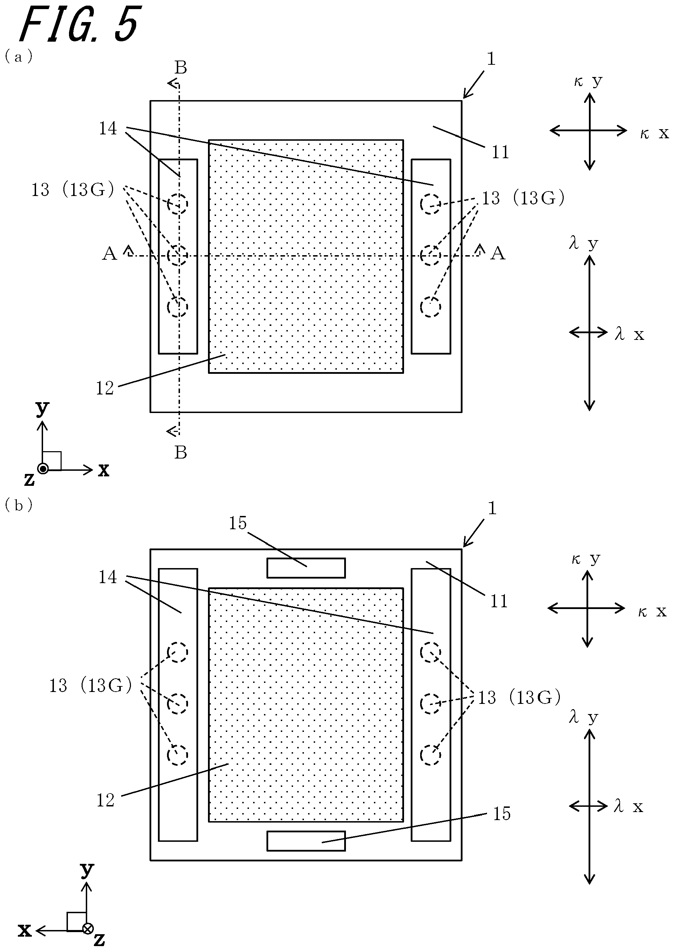

The following describes an electronic device according to a second embodiment of the disclosure with reference to FIGS. 5 to 8.

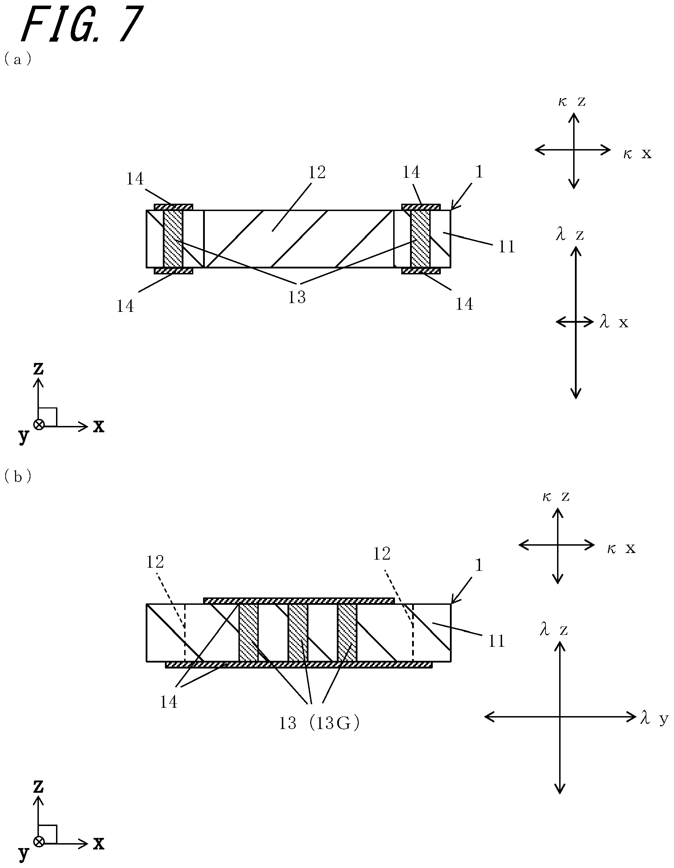

The electronic element mounting substrate 1 according to the second embodiment differs from the electronic element mounting substrate 1 according to the preceding embodiment in that, in the plan view, the plurality of via conductors 13 include a row of via conductors 13 arranged in a direction of greater heat conduction of the second substrate 12 (y direction as viewed in FIGS. 5 to 8). In FIG. 7(b), the outer edge of the second substrate 12 is indicated by dotted lines for purposes of convenience in showing the positional relationship between the first substrate 11 and the second substrate 12.

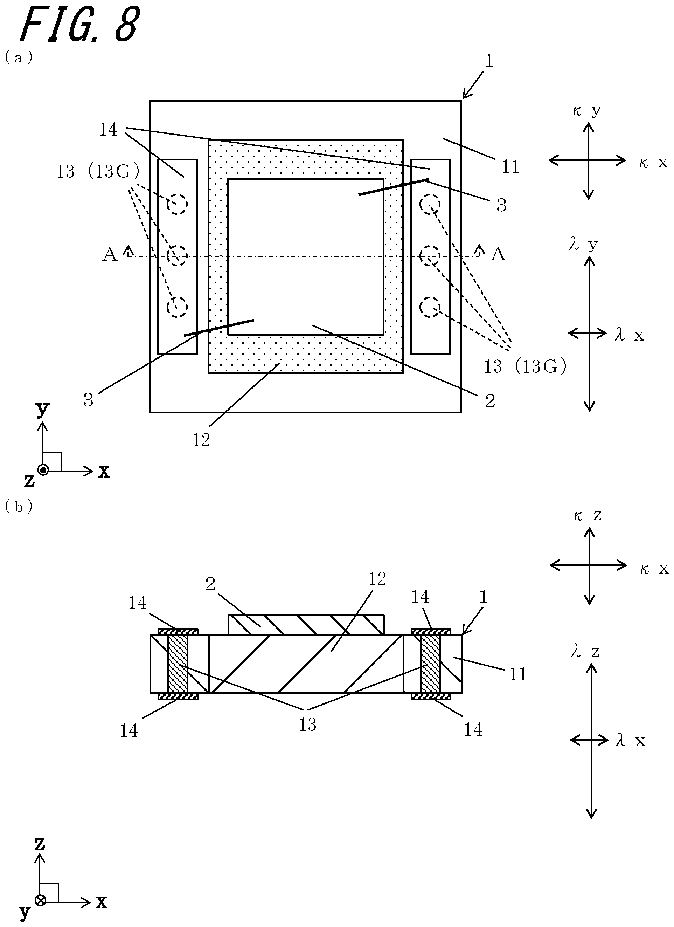

In the electronic element mounting substrate 1 according to the second embodiment, in the plan view, the plurality of via conductors include a row of at least two via conductors 13 arranged in the direction of greater heat conduction of the second substrate 12, thereby constituting a via conductor group 13G. As illustrated in FIGS. 5 to 8, in the plan view, the plurality of via conductors include a row of three via conductors 13 arranged in the direction of greater heat conduction of the second substrate 12, and a plurality of via conductor groups 13G are arranged in the first substrate 11 with the second substrate 12 in between. In the electronic element mounting substrate 1 according to the second embodiment, in the plan view, heat conduction of the second substrate 12 is greater in a direction perpendicular to a direction in which the plurality of via conductor groups 13G are arranged with the second substrate 12 in between (y direction as viewed in FIGS. 5 to 8) than in the direction in which the via conductor groups 13G are arranged with the second substrate 12 in between (x direction as viewed in FIGS. 5 to 8) (λy ≈ λz >> λx). As illustrated in FIG. 8, the electronic element 2 is located on the mounting portion of the second substrate 12 so as to lie between the via conductor groups 13G each including the plurality of via conductors 13.

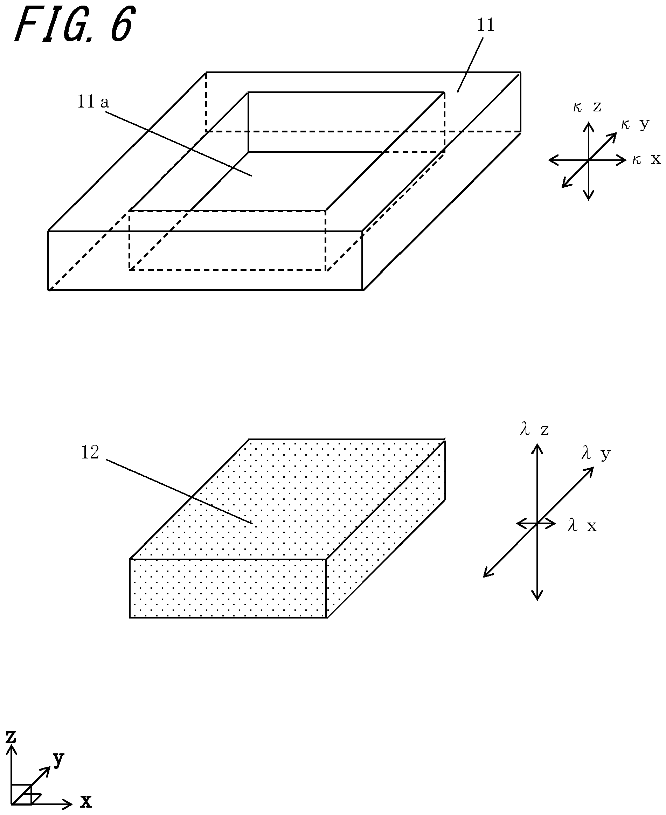

In FIG. 6, in the illustrated first substrate 11, the outer surface of the first substrate 11 and the inner surface of the through hole 11a, which become invisible as viewed in perspective, are indicated by dotted lines. In FIGS. 5, 6, and 8(a), the illustrated second substrate 12 is indicated by a dot-shaded area. In FIGS. 5 and 8(a), in the plan view, a part of overlap of the periphery of the via conductor 13 and the conductor layer 14 is indicated by dotted lines.

In the electronic element mounting substrate 1 according to the second embodiment, as in the electronic element mounting substrate 1 according to the preceding embodiment, in the entire thickness of the via conductor 13 (z direction), the heat transmitted to the second substrate 12 from the via conductor 13 is transmitted from the outer edge area of the second substrate 12 in a direction perpendicular to the direction in which rows of the plurality of via conductors 13 arranged along the outer edge of the first substrate 11 are arranged with the second substrate 12 in between. This makes it possible to reduce transmission of heat from the via conductor 13 to the electronic element 2, to achieve good dissipation of heat from the via conductor 13, and to reduce a decrease in the output of the electronic element 2.

Moreover, in the case where a light-emitting element is used as the electronic element 2, the electronic element mounting substrate is capable of reducing a decrease in the output of the light-emitting element, ensuring satisfactory light emission from the light-emitting element.

Moreover, heat from the electronic element 2 is transmitted both in a direction of the second substrate 12 which is perpendicular to the direction in which rows of the plurality of via conductors 13 are arranged with the second substrate 12 in between and in the thickness direction of the second substrate 12. This permits good dissipation of the heat from the electronic element 2 and thus can reduce a decrease in the output of the electronic element 2.

Moreover, in the electronic element mounting substrate 1 according to the second embodiment, the plurality of via conductors 13 include a row of via conductors 13 arranged in the direction of greater heat conduction of the second substrate 12. With this arrangement of the plurality of via conductors 13, heat from each via conductor 13 is less likely to remain in the interior of the first substrate 11, and thus, in the entire thickness of the via conductor 13 (z direction), the heat transmitted to the second substrate 12 from the via conductor 13 is transmitted from the outer edge area of the second substrate 12 in a direction perpendicular to the direction in which rows of the plurality of via conductors 13 arranged along the outer edge of the first substrate 11 are arranged with the second substrate 12 in between. This makes it possible to reduce transmission of heat from the via conductor 13 to the electronic element 2, to achieve good dissipation of heat from the via conductor 13, and to reduce a decrease in the output of the electronic element 2 effectively.

The first substrate 11 is quadrangular in plan configuration. In the plan view, the first substrate 11 is provided with the quadrangular through hole 11a formed so as to pass through between the first principal face and the second principal face thereof. The first substrate 11 may be shaped in a frame. The second substrate 12 is quadrangular in plan configuration. The periphery of the second substrate 12 is bonded to the inner surface of the through hole 11a of the first substrate 11, thereby constituting a quadrangular composite substrate. As used herein the term "quadrangular configuration" means the shape of a quadrilateral such as a square and a rectangle. As illustrated in FIGS. 5 to 8, the first substrate 11 and the second substrate 12 are each square in plan configuration. Thus, the composite substrate having a square form is formed.

Moreover, preferably, the plurality of via conductor groups 13G include the same number of the via conductors 13. In this case, in the plan view, uniformity can be achieved between the heat transmitted to the second substrate 12 from one of the via conductor groups 13G arranged with the second substrate 12 in between and the heat transmitted to the second substrate 12 from the other. This facilitates attainment of symmetrical thermal distribution. Thus, in the entire thickness of the via conductor 13 (z direction), the heat from the individual via conductor groups can be uniformly transmitted from the outer edge areas of the second substrate 12 in a direction perpendicular to the direction in which rows of the plurality of via conductors 13 arranged along the outer edge of the first substrate 11 are arranged with the second substrate 12 in between. This makes it possible to reduce transmission of heat from the via conductor 13 to the electronic element 2, to achieve good dissipation of heat from the via conductor 13, and to reduce a decrease in the output of the electronic element 2 effectively.

Moreover, the second substrate 12 is quadrangular in plan configuration, and, in the plan view, preferably, the row of the plurality of via conductors 13 (via conductor group 13G) are arranged along each of the opposed sides of the second substrate 12. This facilitates uniform transmission of heat from the via conductor 13 to the second substrate 12 among the plurality of via conductors 13 (via conductor group 13G). Thus, in the entire thickness of the via conductor 13 (z direction), the heat transmitted to the second substrate 12 from the individual via conductors 13 can be uniformly transmitted from the outer edge areas of the second substrate 12 in a direction perpendicular to the direction in which rows of the plurality of via conductors 13 arranged along the outer edge of the first substrate 11 are arranged with the second substrate 12 in between. This makes it possible to reduce transmission of heat from the via conductor 13 to the electronic element 2, to achieve good dissipation of heat from the via conductor 13, and to reduce a decrease in the output of the electronic element 2.

As illustrated in FIG. 5, preferably, in the plan view, each end of the second substrate 12 in the direction of greater heat conduction of the second substrate 12 is located on an outer side of the endmost via conductor 13 in a row of the plurality of via conductors 13 placed in the direction of greater heat conduction of the second substrate 12. This can restrain the heat transmitted to the second substrate 12 from the via conductor 13 from propagating from each end of the second substrate 12 in the direction of greater heat conduction of the second substrate 12 to the electronic element 2, and thus can reduce a decrease in the output of the electronic element 2.

Moreover, as illustrated in FIG. 5(b), preferably, the first substrate 11 includes an auxiliary layer 15 set in a direction perpendicular to the direction in which rows of the plurality of via conductors 13 arranged along the outer edge of the first substrate 11 are arranged with the second substrate 12 in between. The auxiliary layer 15 is connected to the wiring conductor of a wiring substrate or electronic element housing package, or the connection pad of the module substrate. In this case, the heat transmitted to the first substrate 11 is transmitted to the wiring substrate or electronic element housing package, or the module substrate. This permits good dissipation of heat, and thus can reduce a decrease in the output of the electronic element 2 effectively.

Otherwise, the electronic element mounting substrate 1 according to the second embodiment can be manufactured by a similar method to the method of manufacturing the electronic element mounting substrate 1 according to the preceding embodiment.

### (Third Embodiment)

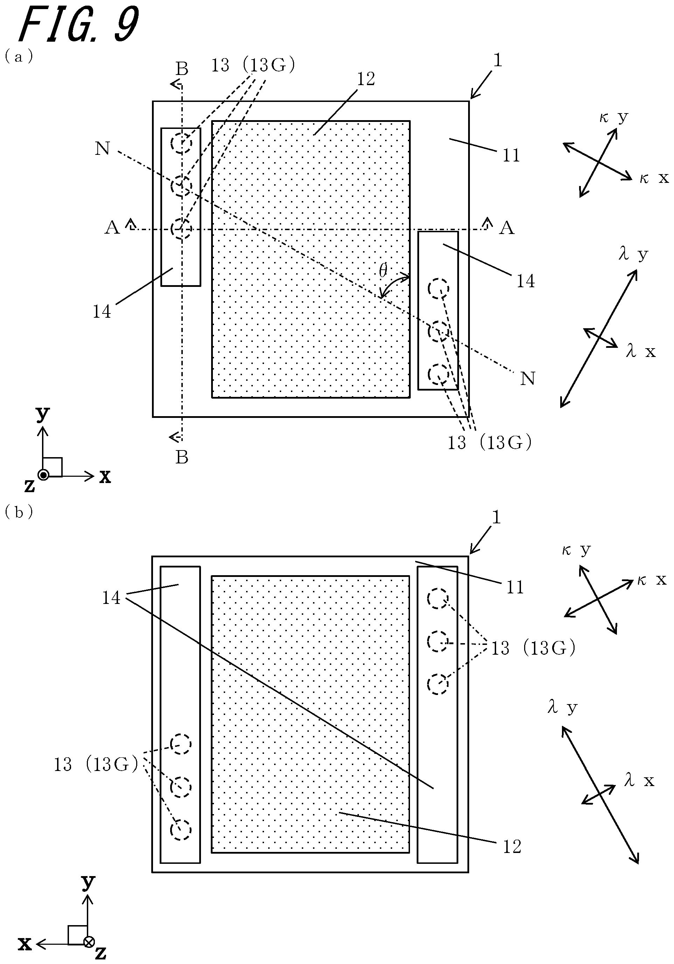

The following describes an electronic device according to a third embodiment of the disclosure with reference to FIGS. 9 to 12.

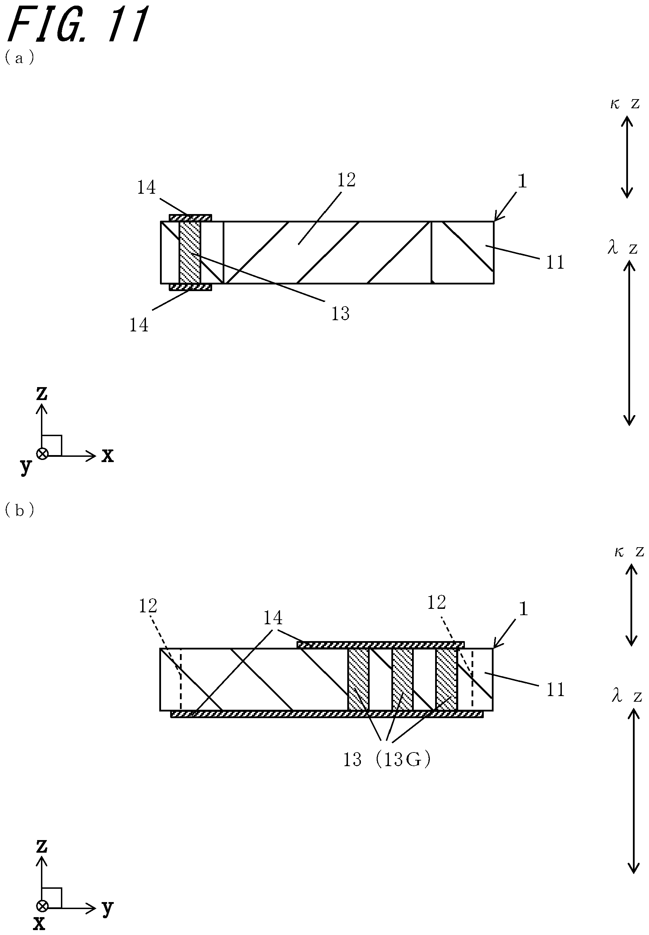

The electronic element mounting substrate 1 according to the third embodiment differs from the electronic element mounting substrate 1 according to the preceding embodiment in that the opposed sides of the second substrate 12 each obliquely intersect a direction in which rows of the plurality of via conductors 13 are arranged with the second substrate 12 in between. In FIG. 11(b), the outer edge of the second substrate 12 is indicated by dotted lines for purposes of convenience in showing the positional relationship between the first substrate 11 and the second substrate 12.

In the electronic element mounting substrate 1 according to the third embodiment, as in the electronic element mounting substrate 1 according to the second embodiment, in the plan view, two or more via conductors 13 are arranged in a row, thereby constituting a via conductor group 13G. As illustrated in FIGS. 9 to 12, in the plan view, three via conductors 13 are arranged in a row, and two via conductor groups 13G are arranged in the first substrate 11 with the second substrate 12 in between.

As described above, the opposed sides of the second substrate 12 each obliquely intersect a direction in which rows of the plurality of via conductors 13 are arranged with the second substrate 12 in between. This means that the opposed sides of the second substrate 12 each obliquely intersect an imaginary straight line N-N passing through the via conductors 13 arranged in the first substrate 11 with the second substrate 12 in between.

As illustrated in FIGS. 9 to 12, in the plan view, the two via conductor groups 13G, which are arranged in the first substrate 11 with the second substrate 12 in between, are symmetric with respect to a point corresponding to the centers of the first substrate 11, the second substrate 12, and the electronic element mounting substrate 1. That is, in the case where the via conductors 13 are provided in the form of the via conductor groups 13G, the opposed sides of the second substrate 12 each obliquely intersect an imaginary straight line N-N passing through the centers of the via conductor groups 13G arranged in the first substrate 11 with the second substrate 12 in between.

In the electronic element mounting substrate 1 according to the third embodiment, heat conduction in a direction perpendicular to a direction in which the plurality of via conductor groups 13G are arranged with the second substrate 12 in between is higher in level than heat conduction in the direction in which the via conductor groups 13G are arranged with the second substrate 12 in between (λy ≈ λz >> λx). In other words, heat conduction in a direction perpendicular to the direction of the imaginary straight line passing through the via conductors 13 (the centers of the via conductor groups 13G) arranged in the first substrate 11 with the second substrate 12 in between is higher in level than heat conduction in the direction of the imaginary straight line passing through the via conductors 13 (the centers of the via conductor groups 13G) arranged in the first substrate 11 with the second substrate 12 in between (λy ≈ λz >> λx).

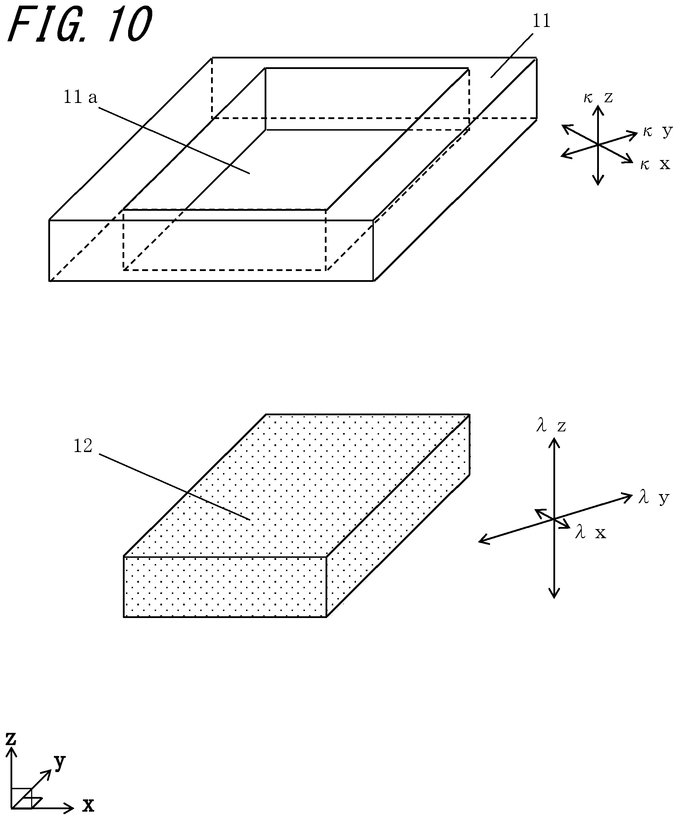

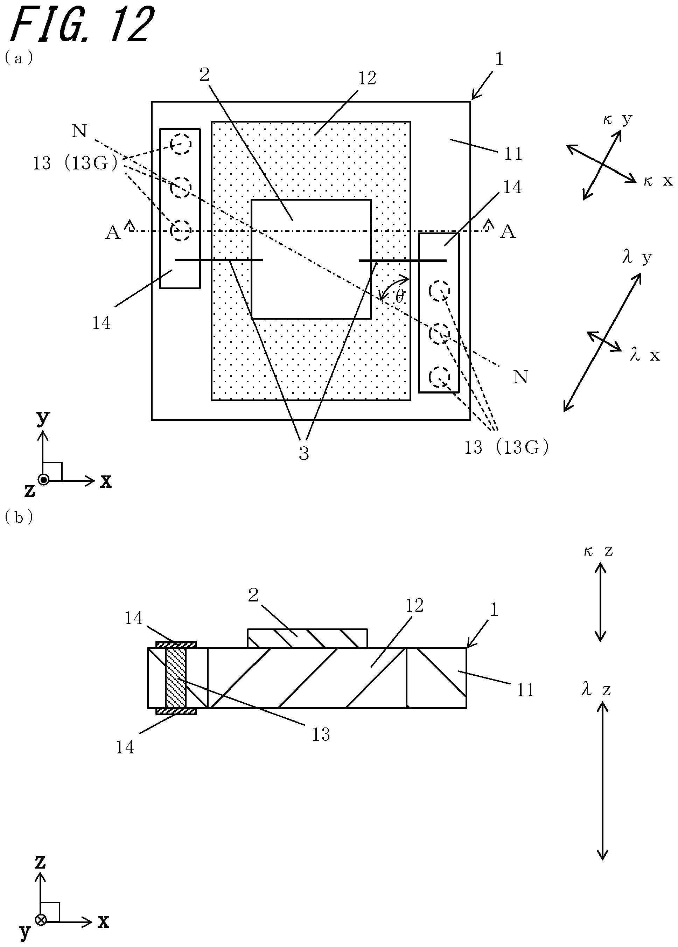

In FIG. 10, in the illustrated first substrate 11, the outer surface of the first substrate 11 and the inner surface of the through hole 11a, which become invisible as viewed in perspective, are indicated by dotted lines. In FIGS. 9, 10, and 12(a), the illustrated second substrate 12 is indicated by a dot-shaded area. In FIGS. 9 and 12(a), in the plan view, a part of overlap of the periphery of the via conductor 13 and the conductor layer 14 is indicated by dotted lines.

In the electronic element mounting substrate 1 according to the third embodiment, as in the electronic element mounting substrate 1 according to the preceding embodiment, in the entire thickness of the via conductor 13 (z direction), the heat transmitted to the second substrate 12 from the via conductor 13 is transmitted from the outer edge area of the second substrate 12 in a direction perpendicular to the direction in which rows of the plurality of via conductors 13 arranged along the outer edge of the first substrate 11 are arranged with the second substrate 12 in between. This makes it possible to reduce transmission of heat from the via conductor 13 to the electronic element 2, to achieve good dissipation of heat from the via conductor 13, and to reduce a decrease in the output of the electronic element 2.

Moreover, the heat transmitted to the second substrate 12 is properly transmitted in a direction perpendicular to the direction of the imaginary straight line passing through the via conductors 13 (the centers of the via conductor groups 13G) arranged opposite to each other within the first substrate 11. Thus, heat from the adjacent via conductors 13 in each via conductor group 13G can be transmitted satisfactorily. This makes it possible to reduce transmission of heat from the via conductor 13 to the electronic element 2, to achieve good dissipation of heat from the via conductor 13, and to reduce a decrease in the output of the electronic element 2.

Moreover, in the case where a light-emitting element is used as the electronic element 2, the electronic element mounting substrate is capable of reducing a decrease in the output of the light-emitting element, ensuring satisfactory light emission from the light-emitting element.

The first substrate 11 is quadrangular in plan configuration. In the plan view, the first substrate 11 is provided with the quadrangular through hole 11a formed so as to pass through between the first principal face and the second principal face thereof. The first substrate 11 may be shaped in a frame. The second substrate 12 is quadrangular in plan configuration. The periphery of the second substrate 12 is bonded to the inner surface of the through hole 11a of the first substrate 11, thereby constituting a quadrangular composite substrate. As used herein the term "quadrangular configuration" means the shape of a quadrilateral such as a square and a rectangle. As illustrated in FIGS. 9 to 12, the first substrate 11 and the second substrate 12 are each square in plan configuration. Thus, the composite substrate having a square form is formed.

Moreover, an angle θ at which one side of the second substrate 12 forms with the imaginary straight line passing through the via conductors 13 (the centers of the via conductor groups 13G) arranged in the first substrate 11 with the second substrate 12 in between may be set at 10 to 80 degrees.

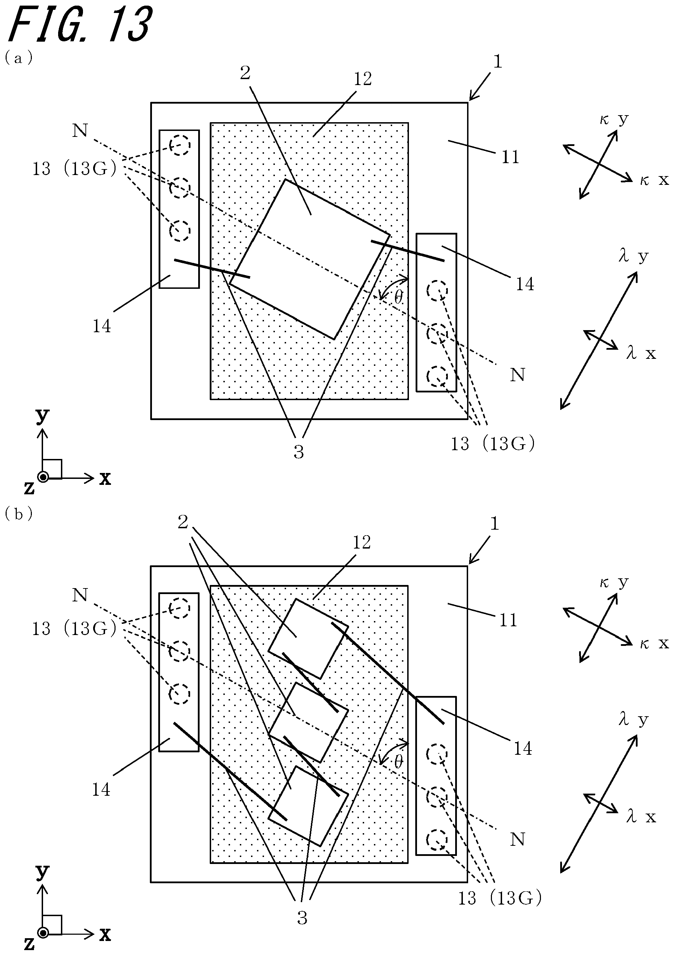

Moreover, as illustrated in FIG. 13(a), preferably, an outer side of the electronic element 2 perpendicularly intersects the direction of the imaginary straight line N-N passing through the via conductors 13 (the centers of the via conductor groups 13G) arranged opposite to each other within the first substrate 11. In this case, the heat transmitted to the second substrate 12 from the plurality of via conductors 13 can be transmitted smoothly away from the electronic element 2. This makes it possible to reduce transmission of heat from the via conductor 13 to the electronic element 2, to achieve good dissipation of heat from the via conductor 13, and to reduce a decrease in the output of the electronic element 2.

Moreover, as illustrated in FIG. 13(b), in the case where a plurality of electronic elements 2 are mounted, preferably, they are arranged in a row so that each electronic element 2 is obliquely oriented with respect to a direction perpendicular to the direction of the imaginary straight line N-N passing through the via conductors 13 (the centers of the via conductor groups 13G) arranged opposite to each other within the first substrate 11. This makes it possible to reduce transmission of heat from the electronic elements 2 in the direction in which the electronic elements 2 are arranged adjacent each other, and thereby reduce a decrease in the output of each electronic element 2.

As illustrated in FIGS. 12 and 13, preferably, the plurality of via conductors 13 are disposed so as not to overlap with the electronic element 2 as viewed in a direction perpendicular to the direction of the imaginary straight line N-N passing through the via conductors 13 (the centers of the via conductor groups 13G) arranged opposite to each other within the first substrate 11. This makes it possible to restrain the heat transmitted to the second substrate 12 from the via conductors 13 against propagation to the electronic element 2, and thereby reduce a decrease in the output of the electronic element 2.

In FIGS. 13(a) and 13(b), as in FIG. 12, in the plan view, a part of overlap of the periphery of the via conductor 13 and the conductor layer 14 is indicated by dotted lines.

Moreover, in the case where a light-emitting element is used as the electronic element 2, the electronic element mounting substrate is capable of reducing a decrease in the output of the light-emitting element, ensuring satisfactory light emission from the light-emitting element.

Such an arrangement that an imaginary straight line representing extension of the outer side of the electronic element 2 does not intersect the via conductor 13 (via conductor group 13G) makes it possible to reduce transmission of heat from the via conductor 13 to the electronic element 2, to achieve good dissipation of heat from the via conductor 13, and to reduce a decrease in the output of the electronic element 2.

Otherwise, the electronic element mounting substrate 1 according to the third embodiment can be manufactured by a similar method to the method of manufacturing the electronic element mounting substrate 1 according to the preceding embodiment.

### (Fourth Embodiment)

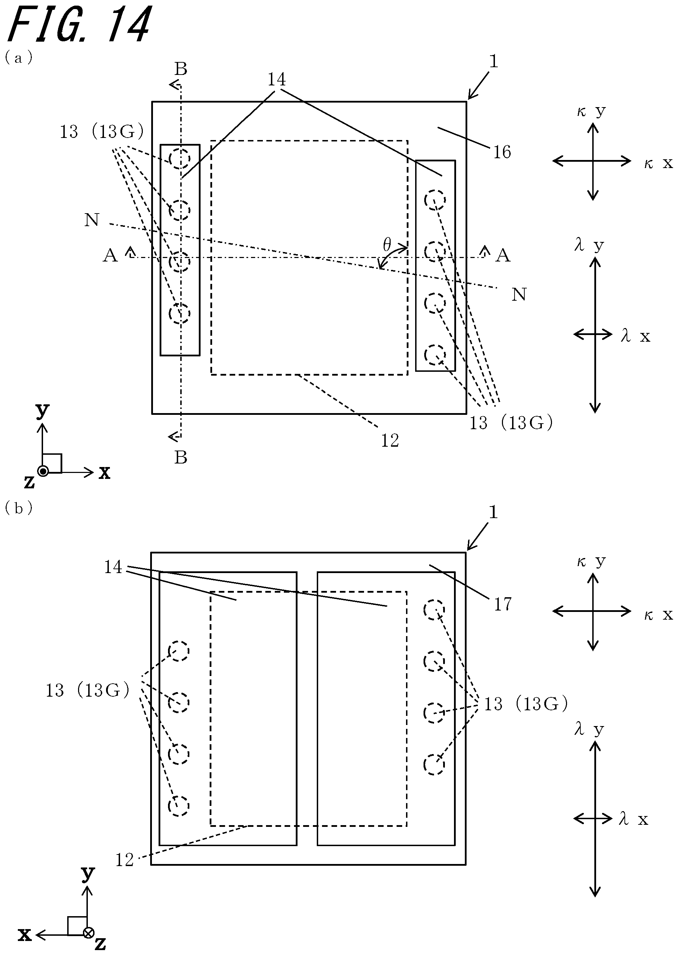

The following describes an electronic device according to a fourth embodiment of the disclosure with reference to FIGS. 14 to 16.

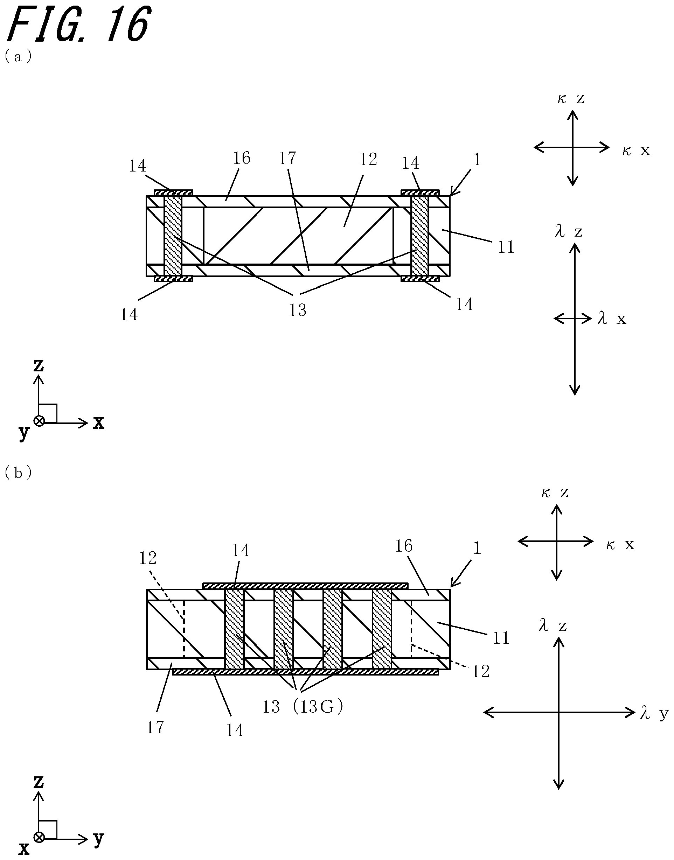

The electronic element mounting substrate 1 according to the fourth embodiment differs from the electronic element mounting substrate 1 according to the preceding embodiment in that the third principal face or the fourth principal face of the second substrate 12 is provided with an additional substrate (third substrate 16, fourth substrate 17). In FIG. 16(b), the outer edge of the second substrate 12 is indicated by dotted lines for purposes of convenience in showing the positional relationship between the first substrate 11 and the second substrate 12.

In the electronic element mounting substrate 1 according to the fourth embodiment, a part of a principal face (upper surface as viewed in FIGS. 14 to 16) of the third substrate 16 which overlies the second substrate 12 is used as a mounting portion for mounting the electronic element 2.

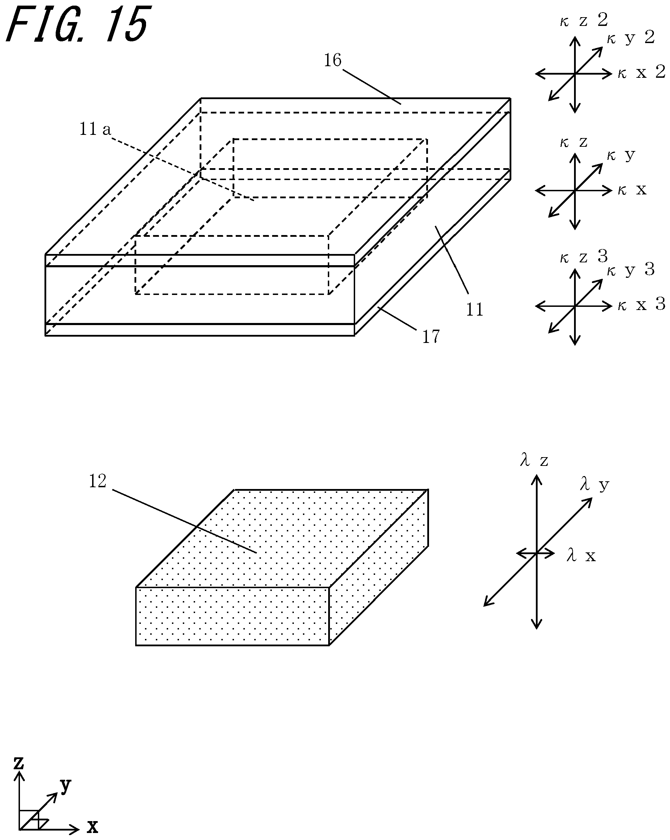

In FIG. 14, in the illustrated first substrate 11, the outer surface of the first substrate 11 and the inner surface of the through hole 11a, which become invisible as viewed in perspective, are indicated by dotted lines. In FIG. 15, the illustrated second substrate 12 is indicated by a dot-shaded area. In FIG. 14, in the transparent plan view, the periphery of the second substrate 12 and a part of overlap of the periphery of the via conductor 13 and the conductor layer 14 are each indicated by dotted lines.

In the electronic element mounting substrate 1 according to the fourth embodiment, as in the electronic element mounting substrate 1 according to the preceding embodiment, in the entire thickness of the via conductor 13 (z direction), the heat transmitted to the second substrate 12 from the via conductor 13 is transmitted from the outer edge area of the second substrate 12 in a direction perpendicular to the direction in which rows of the plurality of via conductors 13 arranged along the outer edge of the first substrate 11 are arranged with the second substrate 12 in between. This makes it possible to reduce transmission of heat from the via conductor 13 to the electronic element 2, to achieve good dissipation of heat from the via conductor 13, and to reduce a decrease in the output of the electronic element 2.

Moreover, as illustrated in FIGS. 14 to 16, formation of a relatively large conductor layer 14 on a principal face (lower surface as viewed in FIGS. 14 to 16) of the fourth substrate 17 permits good bonding with the wiring conductor of a wiring substrate or electronic element housing package, or the connection pad of the module substrate, and thus enables heat from the electronic element 2 to propagate properly to the wiring substrate or electronic element housing package, or the module substrate.

Moreover, in the case where a light-emitting element is used as the electronic element 2, the electronic element mounting substrate is capable of reducing a decrease in the output of the light-emitting element, ensuring satisfactory light emission from the light-emitting element.

The first substrate 11 is quadrangular in plan configuration. In a transparent plan view, the first substrate 11 is provided with the quadrangular through hole 11a formed so as to pass through between the first principal face and the second principal face thereof. The first substrate 11 may be shaped in a frame. The second substrate 12 is quadrangular in plan configuration. The third substrate 16 is quadrangular in plan configuration. The fourth substrate 17 is quadrangular in plan configuration. The periphery of the second substrate 12 is bonded to the inner surface of the through hole 11a of the first substrate 11, and the third principal face and the fourth principal face of the second substrate 12 are bonded to the third substrate 16 and the fourth substrate 17, respectively, thereby constituting a quadrangular composite substrate. Moreover, the first principal face and the second principal face of the first substrate 11 may be bonded to the third substrate 16 and the fourth substrate 17, respectively. As used herein the term "quadrangular configuration" means the shape of a quadrilateral such as a square and a rectangle. As illustrated in FIGS. 14 to 16, the first substrate 11 and the second substrate 12 are each square in plan configuration. Thus, the composite substrate having a square form is formed.

The third substrate 16 and the fourth substrate 17 may be manufactured by using the same material and method as those used for the formation of the first substrate 11 as described above. In the planar direction of each of the third substrate 16 and the fourth substrate 17, as with the first substrate 11, each of a thermal conductivity κ2 of the third substrate 16 and a thermal conductivity κ3 of the fourth substrate 17 in the x direction and a thermal conductivity κ2 and κ3 thereof in the y direction are substantially uniform. Moreover, in the thickness direction of each of the third substrate 16 and the fourth substrate 17, each of a thermal conductivity κ2 of the third substrate 16 and a thermal conductivity κ3 of the fourth substrate 17 in the z direction are approximately equal to the thermal conductivity κ2 in the planar direction, i.e. the x direction and the y direction (κx2 ≈ κy2 ≈ κz2, κx3 ≈ κy3 ≈ κz3). For example, in the case where an aluminum nitride sintered body are used for the third substrate 16 and the fourth substrate 17, the third substrate 16 and the fourth substrate 17 are constructed of a substrate having thermal conductivity κ2 and a substrate having thermal conductivity κ3 of about 100 to 200 W/m·K.

The first substrate 1 and the second substrate 12 are located between the third substrate 16 and the fourth substrate 17. This arrangement reduces warpage of the electronic element mounting substrate 1 resulting from the difference in thermal expansion between the first substrate 11 and the second substrate 12, restrains the electronic element 2 from becoming misaligned or reduces warpage of the electronic element mounting substrate 1, and thus can achieve satisfactory light emission.

It is particularly advisable that the insulator material used for the third substrate 16 and the fourth substrate 17 be substantially identical with the insulator material constituting the first substrate 11. That is, for example, in the case where the first substrate 11 is made of an aluminum nitride sintered body having a thermal conductivity of 150 W/m·K, the aluminum nitride sintered body having a thermal conductivity of 150 W/m·K is used for the third substrate 16 and the fourth substrate 17. This permits more effective reduction of warpage of the electronic element mounting substrate 1, and thus can facilitate satisfactory light emission.

Moreover, for example, the third substrate 16 has a thickness T3 of about 50 um to 500 um, and the fourth substrate 17 has a thickness T4 of about 50 um to 500 um. The thickness T3 of the third substrate 16 and the thickness T4 of the fourth substrate 17 are substantially equal, with an allowable margin between them limited to about 10% (0.90T4 ≤ T3 ≤ 1.10T4). This permits more effective reduction of warpage of the electronic element mounting substrate 1, and thus can facilitate satisfactory light emission. For example, in the case where the thickness T3 of the third substrate 16 is set at 100 µm, the thickness T4 of the fourth substrate 17 is set at 100 um (within the range of 90 um to 110 um).

Moreover, in the case where the thickness T3 of the third substrate 16 is smaller than the thickness T1 of the first substrate 11 and the thickness T2 of the second substrate 12, and also the thickness T4 of the fourth substrate 17 is smaller than the thickness T1 of the first substrate 11 and the thickness T2 of the second substrate 12, then heat from the electronic element 2 can be transmitted properly to the wiring substrate or electronic element housing package, or the module substrate. This permits more effective reduction of warpage of the electronic element mounting substrate 1, and thus can facilitate satisfactory light emission.

As illustrated in FIGS. 14 to 16, the first substrate 11 is shaped in a square frame, and the second substrate 12, the third substrate 16, and the fourth substrate 17 each have a rectangular shape. The first substrate 11, the second substrate 12, the third substrate 16, and the fourth substrate 17 are bonded together into a rectangular composite substrate.

Like the first substrate 11, the third substrate 16 and the fourth substrate 17 are each provided with the via conductor 13 and the conductor layer 14. In the electronic element mounting substrate 1 according to the fourth embodiment, the via conductor 13 and the conductor layer 14 may be formed by using heretofore known thin-film method and plating. For example, after the composite substrate is formed, through holes for forming the via conductor 13 may be made in the composite substrate, and then the via conductor 13 and the conductor layer 14 may be formed.

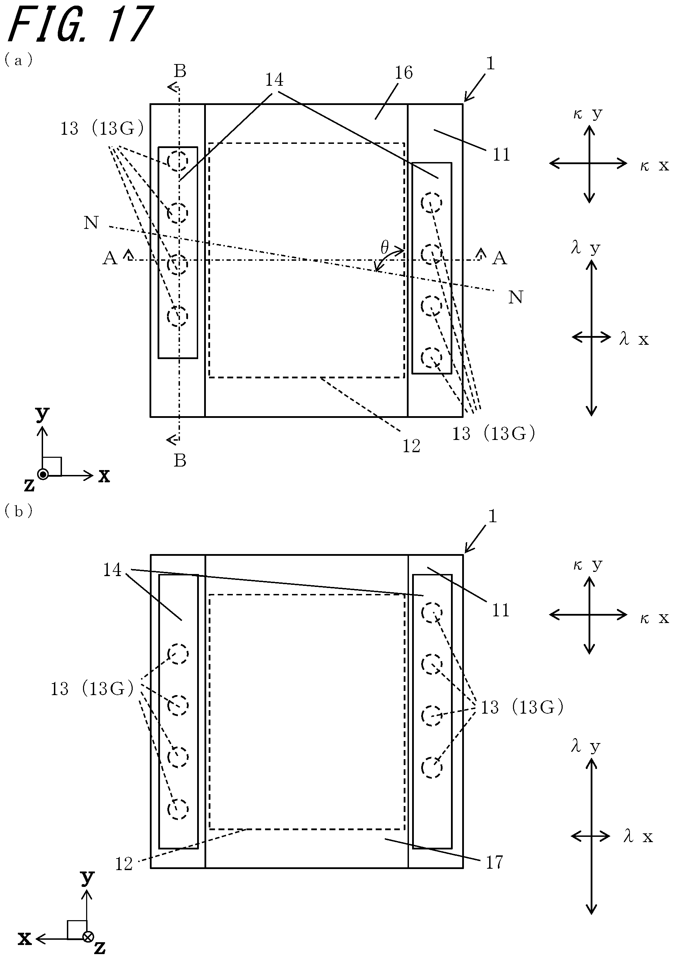

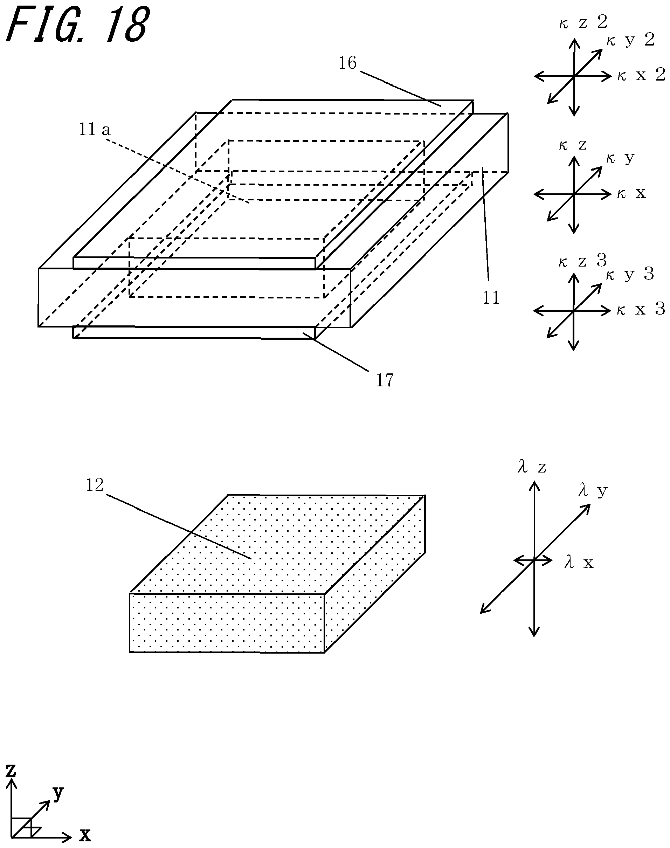

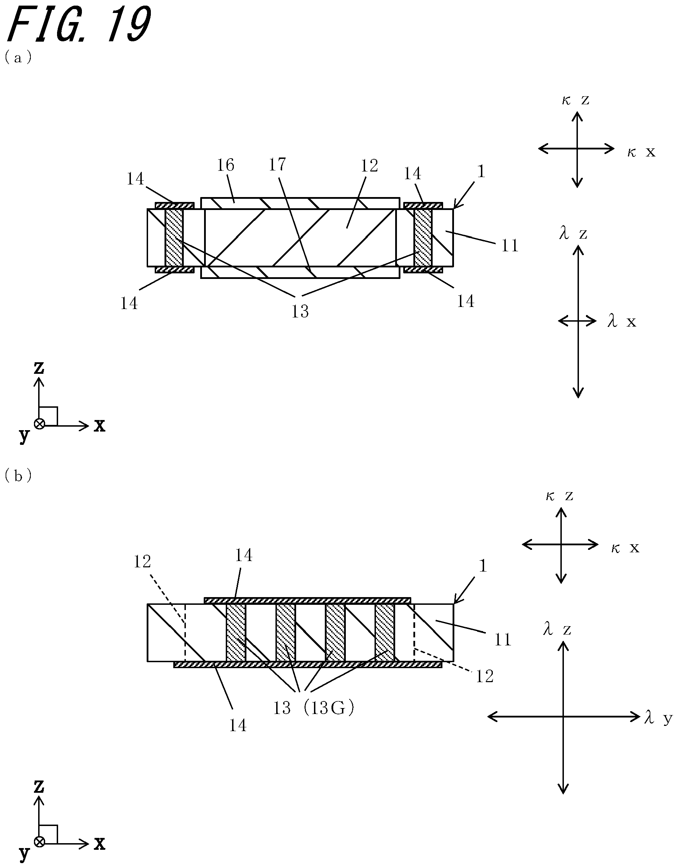

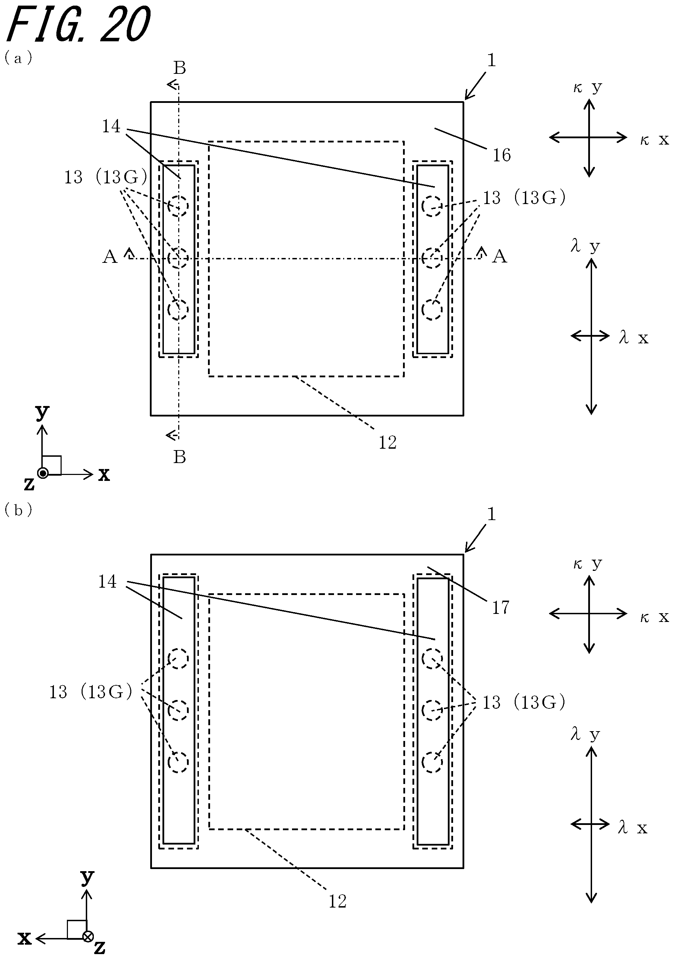

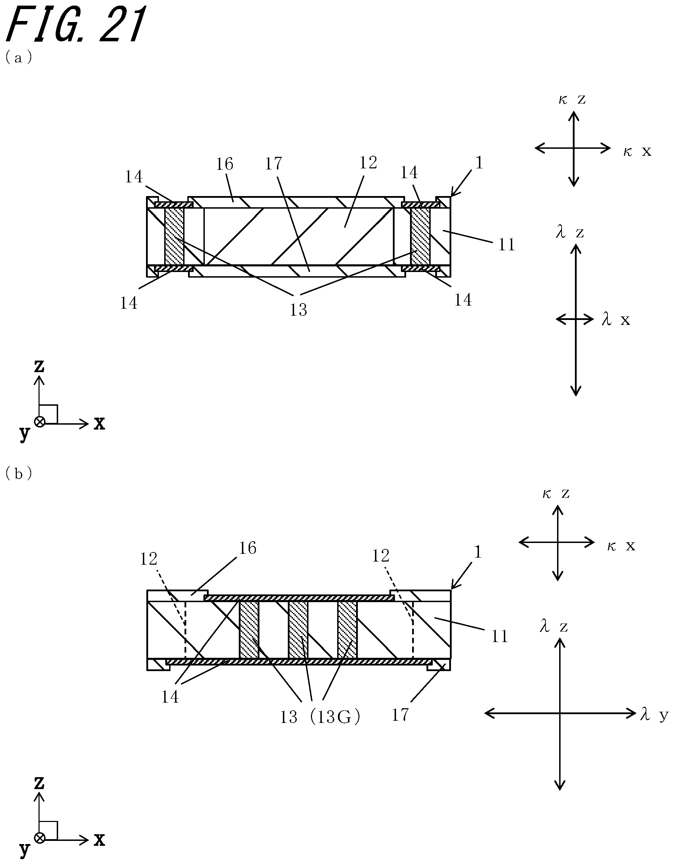

Moreover, as illustrated in FIGS. 17 to 19, the third substrate 16 or the fourth substrate 17 may be placed so as to cover corresponding one of the third principal face and the fourth principal face of the second substrate 12, and also cover corresponding one of an inner edge of the first principal face and an inner edge of the second principal face of the first substrate 11. Alternatively, as illustrated in FIGS. 20 and 21, the third substrate 16 and the fourth substrate 17 may be placed so that the third substrate 16 covers the first principal face of the first substrate 11 and the third principal face of the second substrate 12, and the fourth substrate 17 covers the second principal face of the first substrate 11 and the fourth principal face of the second substrate 12, and the third substrate 16 and the fourth substrate 17 may be each provided with a penetrating portion to uncover the conductor layer 14 disposed on the first substrate 11. This eliminates the need to provide the via conductor 13 and the conductor layer 14 in the third substrate 16 and the fourth substrate 17, and thus permits efficient formation of the electronic element mounting substrate 1. In FIGS. 19(b) and 21(b), the outer edge of the second substrate 12 is indicated by dotted lines for purposes of convenience in showing the positional relationship between the first substrate 11 and the second substrate 12.

Otherwise, the electronic element mounting substrate 1 according to the fourth embodiment can be manufactured by a similar method to the method of manufacturing the electronic element mounting substrate 1 according to the preceding embodiment.

The disclosure is not limited to the embodiments described heretofore, and thus various changes and modifications may be made therein within the scope of the invention as defined by the claims. For example, each of the electronic element mounting substrates 1 according to the first to fourth embodiments may be made in the form of a quadrangular composite substrate having beveled or chamfered corners.

Moreover, for example, like the electronic element mounting substrate 1 according to the fourth embodiment, the electronic element mounting substrate 1 according to the third embodiment may be designed so that the third substrate 16 is placed on the third principal face of the second substrate 12, and the fourth substrate 17 is placed on the fourth principal face of the second substrate 12.

Moreover, the electronic element mounting substrate 1 may be implemented via a combination of the designs of the electronic element mounting substrates 1 according to the first to fourth embodiments. That is, for example, like the electronic element mounting substrate 1 according to the third embodiment, the electronic element mounting substrate 1 according to the fourth embodiment may be designed so that the opposed sides of the second substrate 12 each obliquely intersect the direction in which rows of the plurality of via conductors 13 are arranged with the second substrate 12 in between.

## Claims

1. An electronic element mounting substrate (1), comprising:
a first substrate (11) comprising a first principal face and a second principal face located opposite to the first principal face;
a second substrate (12) located inside the first substrate (11) in a plan view of the electronic element mounting substrate (1), the second substrate (12) comprising a third principal face located on a first principal face side in a thickness direction of the second substrate (12) and a fourth principal face located opposite to the third principal face, the second substrate (12) being made of a carbon material; and
a plurality of via conductors (13) that are, in the plan view of the electronic element mounting substrate (1), arranged in the first substrate (11) with the second substrate (12) in between,
in the plan view of the electronic element mounting substrate (1), heat conduction of the second substrate (12) being greater in a direction perpendicular to a direction in which the plurality of via conductors (13) are arranged with the second substrate (12) in between than in the direction in which the plurality of via conductors (13) are arranged with the second substrate (12) in between.

2. The electronic element mounting substrate (1) according to claim 1,
wherein, in a vertical sectional view of the second substrate (12) in a direction in which the plurality of via conductors (13) are arranged with the second substrate (12) in between in the plan view of the electronic element mounting substrate (1), heat conduction of the second substrate (12) is greater in a thickness direction of the second substrate (12) than in a direction perpendicular to the thickness direction.

3. The electronic element mounting substrate (1) according to claim 1 or 2,
wherein, in the plan view of the electronic element mounting substrate (1), the plurality of via conductors (13) comprise a row of via conductors (13) arranged in the direction of greater heat conduction of the second substrate (12).

4. The electronic element mounting substrate (1) according to any one of claims 1 to 3,
wherein the second substrate (12) is quadrangular in plan configuration thereof, and
in the plan view of the electronic element mounting substrate (1), the plurality of via conductors (13) comprise a row of via conductors (13) arranged along each of opposed sides of the second substrate (12).

5. The electronic element mounting substrate (1) according to any one of claims 1 to 4,
wherein the second substrate (12) is quadrangular in plan configuration thereof, and
in the plan view of the electronic element mounting substrate (1), opposed sides of the second substrate (12) each obliquely intersect the direction in which the plurality of via conductors (13) are arranged with the second substrate (12) in between.

6. An electronic device, comprising:
the electronic element mounting substrate (1) according to any one of claims 1 to 5; and
an electronic element (2) mounted on a mounting portion of the electronic element mounting substrate (1).

7. The electronic device according to claim 6, comprising:
a wiring board or electronic element housing package installed with the electronic element mounting substrate (1) .

8. An electronic module, comprising:
the electronic device according to claim 6 or 7; and
a module substrate to which the electronic device is connected.

## Patentansprüche

1. Elektronisches-Element-Montage-Substrat (1), aufweisend:
ein erstes Substrat (11), aufweisend eine erste Hauptfläche und eine zweite Hauptfläche, die der ersten Hauptfläche gegenüberliegt,
ein zweites Substrat (12), das in einer Draufsicht auf das Elektronisches-Element-Montage-Substrat (1) innerhalb des ersten Substrats (11) angeordnet ist, wobei das zweite Substrat (12) eine dritte Hauptfläche, die sich auf einer Erste-Hauptfläche-Seite in einer Dickenrichtung des zweiten Substrats (12) befindet, und eine vierte Hauptfläche, die sich gegenüber der dritten Hauptfläche befindet, aufweist, wobei das zweite Substrat (12) aus einem Kohlenstoffmaterial hergestellt ist, und
eine Mehrzahl von Durchgangsleitern (13), die in der Draufsicht auf das Elektronisches-Element-Montage-Substrat (1) in dem ersten Substrat (11) mit dem zweiten Substrat (12) dazwischen angeordnet sind,
wobei in der Draufsicht auf das Elektronisches-Element-Montage-Substrat (1) die Wärmeleitung des zweiten Substrats (12) in einer Richtung senkrecht zu einer Richtung, in der die Mehrzahl von Durchgangsleitern (13) mit dem zweiten Substrat (12) dazwischen angeordnet ist, größer als in der Richtung ist, in der die Mehrzahl von Durchgangsleitern (13) mit dem zweiten Substrat (12) dazwischen angeordnet ist.

2. Elektronisches-Element-Montage-Substrat (1) gemäß Anspruch 1,
wobei in einer vertikalen Schnittansicht des zweiten Substrats (12) in einer Richtung, in der die Mehrzahl von Durchgangsleitern (13) mit dem zweiten Substrat (12) dazwischen in der Draufsicht auf das Elektronisches-Element-Montage-Substrat (1) angeordnet ist, die Wärmeleitung des zweiten Substrats (12) in einer Dickenrichtung des zweiten Substrats (12) größer als in einer Richtung senkrecht zur Dickenrichtung ist.

3. Elektronisches-Element-Montage-Substrat (1) gemäß Anspruch 1 oder 2,
wobei in der Draufsicht auf das Elektronisches-Element-Montage-Substrat (1) die Mehrzahl von Durchgangsleitern (13) eine Reihe von Durchgangsleitern (13) aufweist, die in der Richtung der größeren Wärmeleitung des zweiten Substrats (12) angeordnet sind.

4. Elektronisches-Element-Montage-Substrat (1) gemäß irgendeinem der Ansprüche 1 bis 3,
wobei das zweite Substrat (12) in einer Plankonfiguration davon viereckig ist, und
in der Draufsicht auf das Elektronisches-Element-Montage-Substrat (1) die Mehrzahl von Durchgangsleitern (13) eine Reihe von Durchgangsleitern (13) aufweist, die entlang jeder von gegenüberliegenden Seiten des zweiten Substrats (12) angeordnet sind.

5. Elektronisches-Element-Montage-Substrat (1) gemäß irgendeinem der Ansprüche 1 bis 4,
wobei das zweite Substrat (12) in einer Plankonfiguration davon viereckig ist und
in der Draufsicht auf das Elektronisches-Element-Montage-Substrat (1) gegenüberliegende Seiten des zweiten Substrats (12) jeweils schräg die Richtung schneiden, in der die Mehrzahl von Durchgangsleitern (13) mit dem zweiten Substrat (12) dazwischen angeordnet ist.

6. Elektronische Vorrichtung, aufweisend:
das Elektronisches-Element-Montage-Substrat (1) gemäß irgendeinem der Ansprüche 1 bis 5 und
ein elektronisches Element (2), das auf einem Montageabschnitt des Elektronisches-Element-Montage-Substrats (1) montiert ist.

7. Elektronische Vorrichtung gemäß Anspruch 6, aufweisend:
eine Verdrahtungsplatte oder ein Elektronisches-Element-Aufnahmegehäuse, die/das mit dem Elektronisches-Element-Montage-Substrat (1) installiert ist.

8. Elektronisches Modul, aufweisend:
die elektronische Vorrichtung gemäß Anspruch 6 oder 7 und
ein Modulsubstrat, mit dem die elektronische Vorrichtung verbunden ist.

## Revendications

1. Substrat de montage d'élément électronique (1), comprenant :
un premier substrat (11) comprenant une première face principale et une deuxième face principale située à l'opposé de la première face principale ;
un deuxième substrat (12) situé à l'intérieur du premier substrat (11) dans une vue en plan du substrat de montage d'élément électronique (1), le deuxième substrat (12) comprenant une troisième face principale située sur un côté de première face principale dans une direction d'épaisseur du deuxième substrat (12) et une quatrième face principale située à l'opposé de la troisième face principale, le deuxième substrat (12) étant fait d'un matériau de carbone ; et
une pluralité de conducteurs d'interconnexion (13) qui sont, dans la vue en plan du substrat de montage d'élément électronique (1), disposés dans le premier substrat (11) avec le deuxième substrat (12) entre eux,
dans lequel, dans la vue en plan du substrat de montage d'élément électronique (1), la conduction thermique du deuxième substrat (12) est plus grande dans une direction perpendiculaire à une direction dans laquelle la pluralité de conducteurs d'interconnexion (13) sont disposés avec le deuxième substrat (12) entre eux que dans la direction dans laquelle la pluralité de conducteurs d'interconnexion (13) sont disposés avec le deuxième substrat (12) entre eux.

2. Substrat de montage d'élément électronique (1) selon la revendication 1,
dans lequel, dans une vue en coupe verticale du deuxième substrat (12) dans une direction dans laquelle la pluralité de conducteurs d'interconnexion (13) sont disposés avec le deuxième substrat (12) entre eux dans la vue en plan du substrat de montage d'élément électronique (1), la conduction thermique du deuxième substrat (12) est plus grande dans une direction d'épaisseur du deuxième substrat (12) que dans une direction perpendiculaire à la direction d'épaisseur.

3. Substrat de montage d'élément électronique (1) selon la revendication 1 ou 2,
dans lequel, dans la vue en plan du substrat de montage d'élément électronique (1), la pluralité de conducteurs d'interconnexion (13) comprennent une rangée de conducteurs d'interconnexion (13) disposés dans la direction de la plus grande conduction thermique du deuxième substrat (12) .

4. Substrat de montage d'élément électronique (1) selon l'une quelconque des revendications 1 à 3,
dans lequel le deuxième substrat (12) est quadrangulaire dans une configuration en plan de celui-ci, et
dans la vue en plan du substrat de montage d'élément électronique (1), la pluralité de conducteurs d'interconnexion (13) comprennent une rangée de conducteurs d'interconnexion (13) disposés le long de chacun de côtés opposés du deuxième substrat (12).

5. Substrat de montage d'élément électronique (1) selon l'une quelconque des revendications 1 à 4,
dans lequel le deuxième substrat (12) est quadrangulaire dans une configuration en plan de celui-ci, et
dans la vue en plan du substrat de montage d'élément électronique (1), des côtés opposés du deuxième substrat (12) coupent chacun obliquement la direction dans laquelle la pluralité de conducteurs d'interconnexion (13) sont disposés avec le deuxième substrat (12) entre eux.

6. Dispositif électronique, comprenant :
le substrat de montage d'élément électronique (1) selon l'une quelconque des revendications 1 à 5 ; et
un élément électronique (2) monté sur une partie de montage du substrat de montage d'élément électronique (1).

7. Dispositif électronique selon la revendication 6, comprenant :
une carte de câblage ou un boîtier de logement d'élément électronique installé(e) avec le substrat de montage d'élément électronique (1).

8. Module électronique, comprenant :
le dispositif électronique selon la revendication 6 ou 7 ; et
un substrat de module auquel le dispositif électronique est connecté.
